(19) Europäisches Patentamt
European Patent Office
Office européen des brevets

(11) **EP 1 488 193 B1**

(12) **EUROPÄISCHE PATENTSCHRIFT**

(45) Veröffentlichungstag und Bekanntmachung des Hinweises auf die Patenterteilung:
**12.06.2013 Patentblatt 2013/24**

(21) Anmeldenummer: 03712019.3

(22) Anmeldetag: **14.03.2003**

(51) Int Cl.:
*G01Q 80/00* (2010.01)   *B82Y 40/00* (2011.01)
*B82Y 35/00* (2011.01)   *H01J 37/317* (2006.01)
*G01Q 70/06* (2010.01)   *B82Y 10/00* (2011.01)

(86) Internationale Anmeldenummer:
**PCT/EP2003/002680**

(87) Internationale Veröffentlichungsnummer:
**WO 2003/081171 (02.10.2003 Gazette 2003/40)**

(54) **VORRICHTUNG UND VERFAHREN ZUR MASKENLOSEN AFM MIKROLITHOGRAPHIE**

DEVICE AND METHOD FOR MASKLESS AFM MICROLITHOGRAPHY

DISPOSITIF ET PROCEDE DE MICROLITHOGRAPHIE AFM SANS CACHE

(84) Benannte Vertragsstaaten:
**DE FR GB**

(30) Priorität: **21.03.2002 DE 10212736**
**26.01.2003 DE 10303040**

(43) Veröffentlichungstag der Anmeldung:
**22.12.2004 Patentblatt 2004/52**

(73) Patentinhaber:
• **Vistec Electron Beam GmbH**
**07745 Jena (DE)**
• **Rangelow, Ivo**
**34225 Baunatal (DE)**

(72) Erfinder:
• **RANGELOW, Ivo**
**34225 Baunatal (DE)**
• **IVANOV, Tzwetan**
**34131 Kassel (DE)**

• **HUDEK, Peter**
**07743 Jena (DE)**
• **FORTAGNE, Olaf**
**07743 Jena (DE)**

(74) Vertreter: **Reichert, Werner Franz et al**
**Reichert & Kollegen**
**Bismarckplatz 8**
**93047 Regensburg (DE)**

(56) Entgegenhaltungen:
**US-A- 5 856 672    US-B1- 6 189 374**

• **MINNE S C ET AL: "INDEPENDENT PARALLEL LITHOGRAPHY USING THE ATOMIC FORCE MICROSCOPE" JOURNAL OF VACUUM SCIENCE AND TECHNOLOGY: PART B, AMERICAN INSTITUTE OF PHYSICS. NEW YORK, US, Bd. 14, Nr. 4, 1. Juli 1996 (1996-07-01), Seiten 2456-2461, XP000622155 ISSN: 0734-211X**

**Beschreibung**

Die vorliegende Erfindung betrifft eine Vorrichtung zur maskenlosen Mikrolithographie. Im besonderen betrifft die Erfindung eine Vorrichtung zur maskenlosen Mikrolithographie mit einem mikrostrukturierten Ausleger, der an einem freien Ende eine Nadelspitze trägt.

Ferner betrifft die Erfindung ein Verfahren zur maskenlosen Mikrolithographie.

Der Fortschritt in der Forschung und Entwicklung von mikroelektronischen Bauteilen hängt hauptsächlich von den Eigenschaften, den Fähigkeiten und der Flexibilität der mikrolithographischen Geräte ab. Der Fortschritt ist unter anderem in dem Bestreben zur Erzielung von immer feineren Strukturen und somit einer möglichst hohen Packungsdichte begründet. Die Lithographie in der Mikroelektronik ist ein technologischer Prozessschritt, bei dem das Muster in ein Aufzeichnungsmedium gezeichnet bzw. projiziert wird. In der Regel ist der strahlungsempfindliche dünne Film ein Resist. In dem dünnen Film wird das gewünschte Muster des Bauteils geschrieben und die daraus resultierende Struktur im Medium wird als Maske bezeichnet, wobei Photonen, Elektronen, oder Ionen zum Schreiben verwendet werden. Während des Prozesses bzw. Schreibvorganges werden im Resist feine Linienmuster ausgebildet, die selektiv das darunter liegende Substrat gegen chemische oder physikalische Einwirkung in den nachfolgenden Prozessschritten, wie z.B. Ätzen, Metallisierung, Dotieren, Implantieren etc., schützen.

Die Verwendung von Elektronen in der Lithographie ist hauptsächlich auf das seriell arbeitende Direktschreiben auf Substrate oder die Master-Masken Fertigung für andere lithographische Projektionstechniken mit hauptsächlich hohem, parallelen Durchsatz beschränkt.

Die internationale Patentanmeldung WO 00/30146 beschreibt ein Verfahren und eine Anordnung zum Belichten eines Substrats. Dabei ist das Substrat mit einem aus N-Schichten bestehenden Resistsystem versehen, das mit einer Korpuskularstrahlung belichtet oder bearbeitet wird. Die Anordnung zur Belichtung der Bearbeitung besteht aus mehreren Kontaktspitzen, die durch ein Federelement mit den verschiedenen Schichten des Resistsystems in Kontakt gebracht werden. Dabei kontaktieren verschiedene Kontaktspitzen unterschiedliche Schichten des Resistsystems, um dadurch eine Aufladung der einzelnen Schichten während der Strukturierung durch die Korpuskularstrahlung zu verhindern. Dennoch erfolgt die Belichtung bzw. Bearbeitung des Substrats weiterhin über eine einzige Quelle der Korpuskularstrahlung, was für die Bearbeitung einer gesamten Wafer- oder Substratoberfläche zeitaufwendig ist. US 6189374 beschreibt eine Vorrichtung zur abbildenden Rasterkraftmikroskopie.

Der Artikel von Kathryn Wilder und Calvin F. Quante in Journal Vac. Sci. Technol. B 17(6) , Nov/Dec 1999, Seiten 3256 bis 3261, offenbart eine Methode zur Lithographie, die einen Ausleger mit einem integrierten Transistor zur Steuerung des Belichtungsstroms umfasst. Die von einer mikrostrukturierten Spitze aufgrund von Feldemission ausgesendeten Elektronen wirken auf einen Resist aus organischem Polymer ein. Ein MOSFET ist auf dem Ausleger integriert und kontrolliert die von der Spitze ausgesendete Elektronendosis. Der Ausleger und die Spitze bilden die Senke des MOSFETs.

US-5856672 und XP622155 [J. Vac. Sci. Techn. B14 (4), Jul/Aug 1996, pp2456; s.c. Minne et al: "Independent parallel lithography etc."] beschreiben beiden ein mikrolithographisches Verfahren samt Vorrichtung als nächster Stand der Technik. Diese basieren auf einfache, gitterlose Emitter-Kathoden und bieten Keine Möglichkeit der Spotgröße.

Die Nachteile des Standes der Technik sind, dass die Direktschreibverfahren und Vorrichtungen, die Elektronen verwenden, im Vergleich zu lithographischen Projektionstechniken zu langsam sind. Dennoch ermöglicht das Direktschreiben die Herstellung von Masken mit sehr hoher Auflösung, sehr guter Reproduzierbarkeit und ausgezeichnete, feine Strukturen, die für eine Kontrolle der Platzierung und Ausrichtung von Muster und Kanten besonders nützlich sind.

Der Erfindung liegt daher die Aufgabe zugrunde, eine Vorrichtung zu schaffen, mit der ein schnelles, sicheres und effizientes Direktschreiben auf einem Wafer oder einem Substrat möglich ist.

Die Aufgabe wird erfindungsgemäß gelöst mit einer Vorrichtung wie im Anspruch 1 definiert.

Eine weitere Aufgabe der Erfindung ist es ein Verfahren zu schaffen das ein schnelles, sicheres und effizientes Direktschreiben ermöglich, wie im Anspruch 13 definiert. Dabei soll der Durchsatz von zu schreibenden Masken oder Wafern hoch sein.

Die Vorrichtung zum Direktschreiben hat den entscheidenden Vorteil, dass die Vorrichtung dieser Erfindung ein Array aus Auslegern von Silizium umfasst. Die Ausleger sind mit mikroskopischen Herstellungsverfahren, also mikrostrukturiert, gefertigt. Jeder Ausleger besitzt eine Nadelspitze zur gattergesteuerten Feldemission in der Nähe seines freien Endes. Das Substrat ist als Annode aufzufassen und die Nadelspitze ist die Kathode. Die durch die Feldemission erzeugte Spotgröße auf dem Substrat kann durch das Verhältnis der Anodenspannung $V_a$ zu der Kathodenspannung $V_k$ eingestellt werden. Die eine Elektronenquelle ist eine so genannte Mikrokathode. Ferner besitzt jeder Ausleger eine Struktur zur Richten und Regeln der Ausleger und der von den Nadelspitzen ausgehenden Feldemission. Dabei ist das Richten und Regeln des von der Nadelspitze austretenden Elektronenstrahls und / oder der elektromagnetischen Energie zu verstehen, die an Nadelspitze der Feldemission anliegt.

Es ist besonders vorteilhaft, dass mehrere mikrostrukturierte Ausleger in einem Array angeordnet sind, wobei in jedem Ausleger des Arrays ein Aktuator integriert ist. Eine Spannungsversorgungs- und Kontrolleinheit ist vorgesehen, die durch eine geeignete Spannung den Abstand des Auslegers bezüglich einer zu strukturierenden Oberfläche anpasst. Jede Nadelspitze ist mit dieser Spannungsversorgungs- und Kontrolleinheit verbunden ist. In einer besonders vorteilhaften Ausgestaltung ist die Anordnung der Ausleger in dem Array als eine Reihe ausgebildet ist, und dass die Länge der Reihe etwa dem Durchmesser des Wafers umfasst, der die zu strukturierende Schicht trägt. Zum Strukturieren der zu bemusternden Oberfläche des Substrats oder der Oberfläche des zweiten Wafer ist es erforderlich, dass mindestens ein Array mit Auslegern, von denen jeder eine Nadelspitze trägt mit der zu strukturierenden Oberfläche derart zusammengebracht werden, dass die Nadelspitzen nahe der zu strukturierenden Oberfläche angeordnet sind. Es werden Oszillationen der in Arrays angeordneten Ausleger erzeugt und der Abstand zwischen der an jedem Ausleger vorgesehenen Nadelspitze und der zu strukturierenden Oberfläche wird in geeigneter Weise geregelt bzw. bei einem konstanten Wert gehalten. Eine Relativbewegung zwischen dem mindestens einem Array mit den Auslegern und der zu strukturierenden Oberfläche ermöglicht eine Strukturierung der gesamten Oberfläche. In einer scannenden Bewegung wird die gesamte Oberfläche des zu bemusternden Substrats oder des zu strukturierenden Wafers überdeckt. Durch das Anlegen einer elektrischen Spannung an die Nadelspitze wird ein elektrisches Feld zwischen der Nadelspitze und der Oberfläche ausgebildet, und angelegte Spannung in Abhängigkeit des auf der Oberfläche zu erzeugenden Musters gesteuert und geregelt wird. Der Abstand der Nadelspitze des Auslegers zu der zu strukturierenden Oberfläche wird über die gemessene Phasenverschiebung eines jeden Auslegers angepasst. Wobei die Richtung des Schwingens der einzelnen Ausleger senkrecht zu der zu bemusternden oder strukturierenden Oberfläche eines Substrats oder eines Wafers ist. Die Phasenverschiebung ist ein Maß für den Abstand des Auslegers von der zu bemusternden oder strukturierenden Oberfläche. So ist es möglich, dass über die Spannungsversorgungs- und Kontrolleinheit die Phasenverschiebung auf einen konstanten Wert eingestellt werden kann, was Wiederum einem konstanten Abstand des Auslegers zu der zu strukturierenden Oberfläche entspricht.

Die Erfindung wird im folgenden anhand der in den Figuren schematisch dargestellten Beispiele verdeutlicht. Dabei zeigen:

Fig. 1: eine schematische Seitenansicht; eines Auslegers im Wirkzusammenhang mit einer zu strukturierenden Oberfläche;

Fig. 2: eine schematische Detailansicht der Nadelspitze zum Aussenden der durch Feldemission erzeugten Korpuskularstrahlung;

Fig. 3a: ein schematischer Querschnitt der Nadelspitze bei einem ersten Verhältnis der Anodenspannung und der Kathodenspannung;

Fig. 3b: ein schematischer Querschnitt der Nadelspitze bei einem zweiten Verhältnis der Anodenspannung und der Kathodenspannung;

Fig. 3c: ein schematischer Querschnitt der Nadelspitze bei einem dritten Verhältnis der Anodenspannung und der Kathodenspannung;

Fig. 4: eine Ansicht des Auslegers mit den auf dem Ausleger strukturierten Leitungen zur Steuerung und Kontrolle des Auslegers;

Fig. 5: eine Darstellung der Phasenverschiebung bei der Entfernung von der und der Annäherung an die zu strukturierende Oberfläche der swingenden Ausleger;

Fig. 6: eine schematische Darstellung des Schichtaufbaus des Auslegers;

Fig. 7 eine detaillierte Darstellung der Beschaltung des Auslegers mit der Spannungsversorgungs- und Kontrolleinheit;

Fig. 8 eine graphische Darstellung der Resonanz und der Phasenverschiebung eines Auslegers sowohl im Vakuum als auch in Luft;

Fig. 9 eine Darstellung der mit dem Piezowiderstandssensor gemessenen Spannung als Funktion der Frequenz, mit der der Ausleger vibriert oder schwingt;

Fig. 10: eine Ausführungsform einer Reihenanordnung mehrerer Ausleger zur maskenlosen Mikrolithographie; und

Fig. 11: eine perspektivische Darstellung eines Matrixanordnung mehrerer Ausleger zur maskenlosen Mikrolithographie.

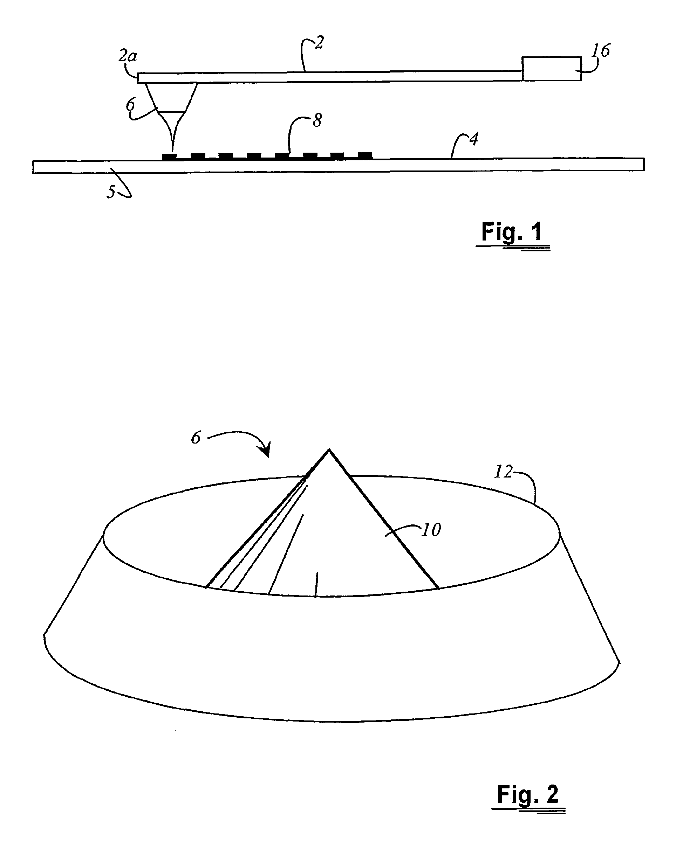

Fig. 1 zeigt eine schematische Seitenansicht; eines Auslegers 2 im Wirkzusammenhang mit einer zu strukturierenden Oberfläche 4 eines Substrats 5 (oder Wafers). Der Ausleger 2 besitzt an einem freien Ende 2a eine Nadel-spitze 6, die zur gittergesteuerten Feldemission benutzt wird und in der Oberfläche 4 eine vorbestimmte Struktur 8 erzeugt. Die Nadelspitze 6 ist eine Mikrokathode und somit die Elektronenquelle für die Feldemission. Der Ausleger 2 ist mit einem Basisteil 16 verbunden.

Fig. 2 zeigt eine perspektivische Detailansicht der Nadelspitze 6. Die Nadelspitze 6 besteht aus der Spitze 10 und einem Ring 12, der die Spitze 10 derart umgibt, dass die Spitze 10 teilweise aus dem Ring 12 herausragt.

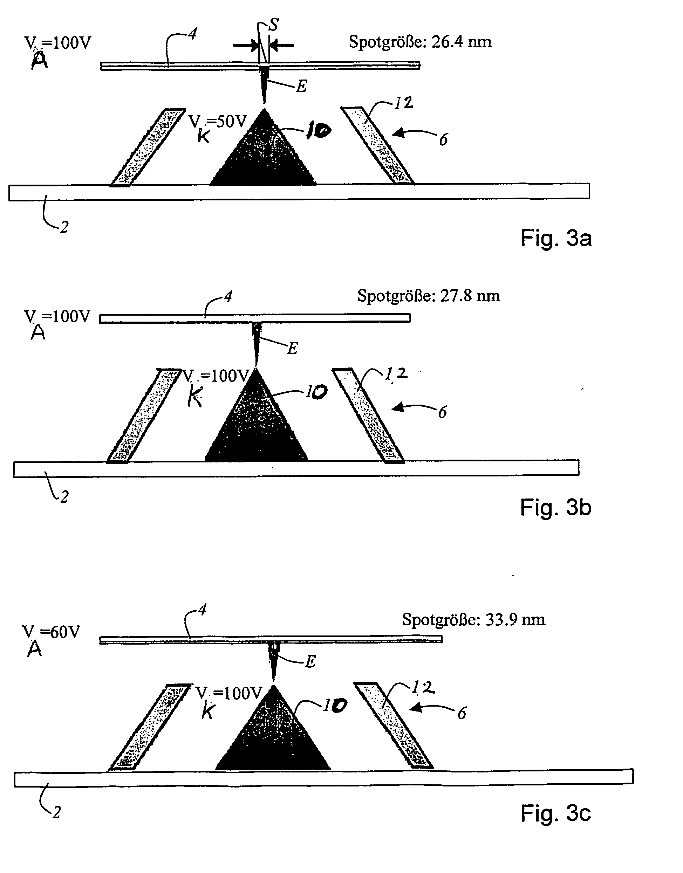

Die Fign. 3a bis 3c zeigen einen schematischen Querschnitt der Nadelspitze 6 bei einem ersten Verhältnis der Anodenspannung (Gitter) und der Kathodenspannung. Wie bereits in Fig. 2 beschrieben besteht die Nadelspitze 6 aus einem Ring 12 der die Spitze 10 umgibt. Die Kathodenspannung $V_k$ liegt zwischen dem Ring 12 und der Spitze an. Die Kathodenspannung $V_k$ liegt ständig an und die Anodenspannung $V_a$ wird dann angeschaltet, wenn ein Elektronenstrahl E zum Schreiben auf dem Substrat oder der zu strukturierenden Oberfläche 4 benötigt wird. Wie aus Fig. 3a ersichtlich ist, beträgt bei einer Kathodenspannung $V_k$ von 100V und einer Anodenspannung $V_a$ von 50V die Spotgröße 26,4 nm.
Fig. 3b ist ein schematischer Querschnitt der Nadelspitze 6 bei einem zweiten Verhältnis der Anodenspannung und der Kathodenspannung. Wie aus Fig. 3b ersichtlich ist, beträgt bei einer Kathodenspannung $V_k$ von 100V und einer Anodenspannung $V_a$ von 100V die Spotgröße 27,8 nm.
Fig. 3c ist ein schematischer Querschnitt der Nadelspitze 6 bei einem dritten Verhältnis der Anodenspannung und der Kathodenspannung. Wie aus Fig. 3c ersichtlich ist, beträgt bei einer Kathodenspannung $V_k$ von 60V und einer Anodenspannung $V_a$ von 100V die Spotgröße 33,9 nm.

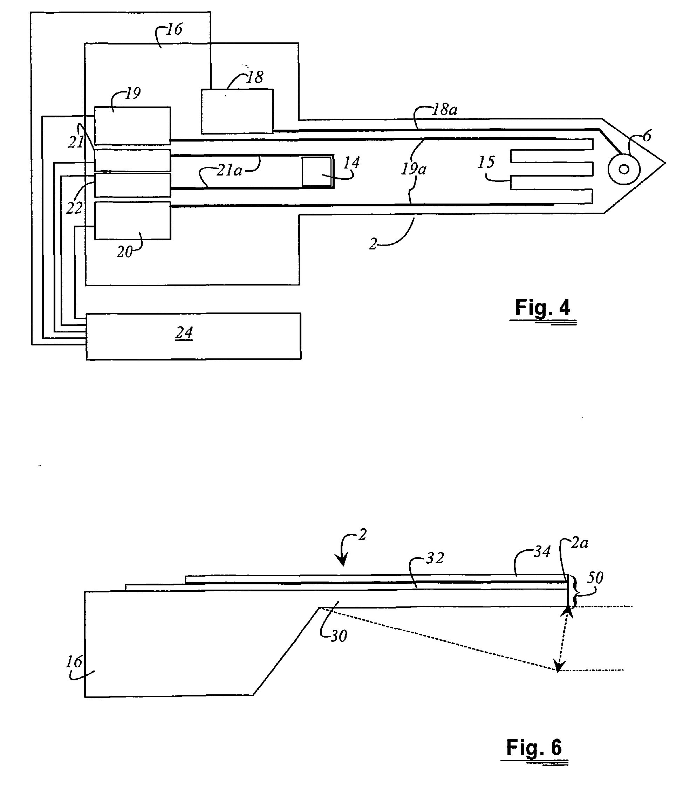

Fig.4 ist eine Ansicht des Auslegers 2 mit den auf dem Ausleger strukturierten Leitungen 18a, 19a, 21a zur Steuerung und Kontrolle des Auslegers 2. In diesem Ausführungsbeispiel besitzt der Ausleger 2 eine Nadelspitze 6 für die Feldemission. Während des Schreibprozesses befindet sich die Nadelspitze 6 des Auslegers 2 nahe der zu strukturierenden Oberfläche 4 (siehe Fig. 1) des Aufzeichnungsmediums, das ein Wafer oder eine Maske für die Lithographie sein kann. Beim Schreibprozess schwingt bzw. vibriert der Ausleger 2 und somit auch die Nadelspitze 6, die freien Ende 2a des Auslegers 2 vorgesehen ist. Die Schwingungsfrequenz ist die Resonanzfrequenz (Grundfrequenz oder Eigenmoden hiervon) des Auslegers 2. Da sich die Nadelspitze 6 des Auslegers 2 extrem nahe der zu strukturierenden Oberfläche 4 des Substrats 5 befindet, ist die Resonanzfrequenz zum Teil von Van der Waals Kräften und /oder anderen zusätzlichen kräften abhängig, die zu einer Dämpfung führen. Die Dämpfung ist von der Größe der wirkenden Kräfte abhängig, was zu einer Phasenverschiebung der Resonanzfrequenz führt. Es liegt somit zwischen der Resonanzfrequenz des Auslegers 2, der weit von der zu strukturierenden Oberfläche 4 entfernt ist und dem Ausleger 2 der sich nahe an der zu strukturierenden Oberfläche befindet, eine Phasenverschiebung vor. In der Realität ist es der Gradient dieser Kräfte, der zu der Phasenverschiebung der Resonanzfrequenzen des Auslegers 2 führt. Während sich der Abstand zwischen der Nadelspitze 6 und der Oberfläche 4 des Substrats 5 verändert, ändern sich auch diese Kräfte, und im Gegenzug verändert die Phasenverschiebung der Resonanzfrequenz des Auslegers 2.

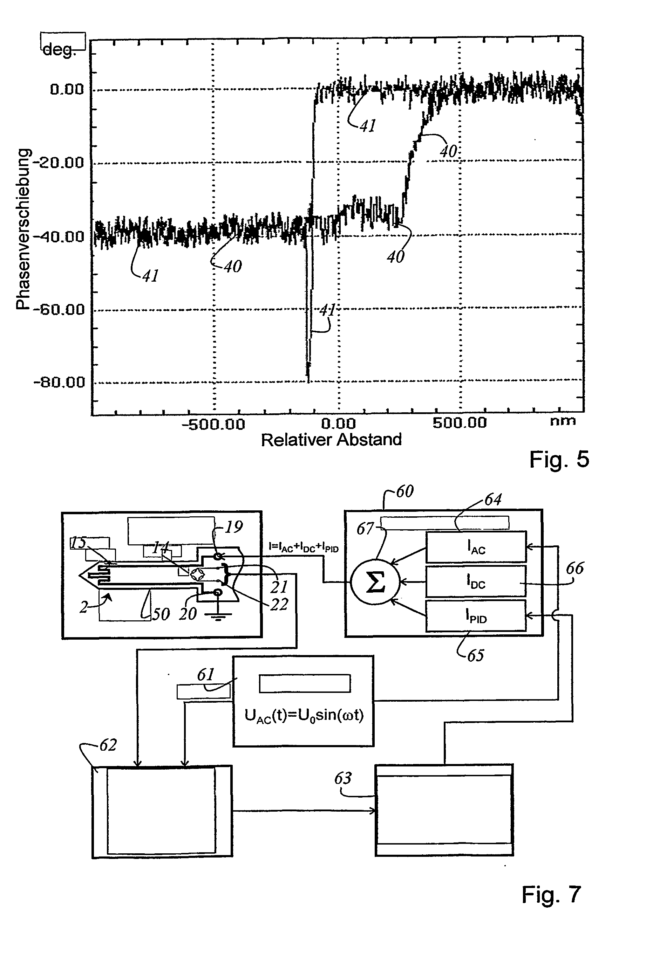

Fig. 5 ist eine Darstellung der Phasenverschiebung bei der Entfernung und der Annäherung der am Ausleger 2 vorgesehenen Nadelspitze 6. Auf der x-Achse ist der relative Abstand der Nadelspitze 6 zu der zu strukturierenden Oberfläche 4 dargestellt. Auf der y-Achse ist die Phasenverschiebung bei der Annäherung bzw. der Entfernung aufgetragen. Eine erste Kurve 40 stellt die Entfernung der Nadelspitze 6 von der zu strukturierenden Oberfläche 4 dar. Befindet sich die Nadelspitze 6 in der Nähe der zu strukturierenden Oberfläche 4, so herrscht in diesem Fall z.B. eine Phasenverschiebung von ca. 40°. Bei dem in der graphischen Darstellung gezeigte relativen Nulldurchgang beginnt sich die Phasenverschiebung allmählich zu verringern und erreicht bei einem gewissen relativen Abstand den Wert von 0°. Bei der Annäherung der Nadelspitze 6 an die zu strukturierende Oberfläche 4 verbleibt die Phasenverschiebung bei 0° und springt bei einem Abstand in der Nähe des relativen Nulldurchgangs auf bis auf einen Betrag von -80° und stellt sich auf -40° ein. Der Bereich der ersten Kurve 40 der den wenig verrauschten Anstieg 40a aufweist kann zur Einstellung einer bestimmten Phasenverschiebung und somit eines bestimmten Abstandes zwischen der Nadelspitze 6 und der zu strukturierenden Oberfläche 4.
Die Resonanzfrequenz bzw. die Phasenverschiebung des Auslegers 2 wird genau bestimmt und eine Spannungsversorgungs- und Kontrolleinheit 24 ermöglicht es in passender Art und Weise den Abstand zwischen der Nadelspitze 6 und der Oberfläche 4 des Substrats 5 anzupassen, so dass die Phasenverschiebung bei einer konstanten Größe gehalten wird. Als Ergebnis davon wird der Abstand zwischen der Substratoberfläche und der Nadelspitze 6 des Auslegers 2 bei einer konstanten Größe gehalten. Dieser Abstand muss genau überwacht bzw. einbestellt werden, um sicher zu stellen, dass nur das gewünschte Gebiet des Aufzeichnungsmediums auf der Oberfläche 4 des Substrats 5 der Elektronenstrahlung ausgesetzt ist und um eine Beschädigung oder einen Crash der Nadelspitze 6 mit der zu strukturierenden Oberfläche 4 zu vermeiden. Alternativ dazu können die Oszillationen des Auslegers 2 bestimmt werden. Diese Information kann verwendet werden, um den Abstand zwischen der Oberfläche 4 des Auszeichnungsmediums bzw. der Oberfläche 4 des Substrats 5 und der schreibenden Nadelspitze 6 des Auslegers 2 zu kontrollieren.

Der Ausleger 2 (siehe Fig. 4) ist mit einem Piezowiderstandssensor 14 versehen detektiert, der direkt im Ausleger 2 eingebettet ist. Die Detektion erfolgt derart, dass sich der Widerstand und somit die Spannung am Piezowiderstandssensor 14 mit jeder Biegung des Auslegers 2 ändert. Die Änderungen des Widerstandes werden mit dem Piezowiderstandssensor 14 bestimmt und stellen ein Signal zur Verfügung, das auf die Phasenverschiebung des Auslegers 2 hindeutet. Diese Information wird über die Anschlüsse 21 und 22 einer Spannungsversorgungs- und Kontrolleinheit 24 zugeführt, um den Abstand zwischen der Nadelspitze 6 und der Oberfläche 4 des Substrats 5 einzustellen und zu regeln. Der Ausleger 2 ist mit einem Basisteil 16 versehen, auf dem ein elektrischer Anschluss 18 für die Nadelspitze 6 und eine Leiterbahn 18a von dem Anschluss 18 zur Nadelspitze 6 strukturiert ist. Auf dem Basisteil 16 ist ein elektrischer Anschluss 19 und 20 strukturiert, die beide mit einer Leiterbahn 19a verbunden sind, die ein Heizelement 15 mit einer Spannung versorgen.

In bevorzugter Weise besitzt der Ausleger 6 einen Biegeabschnitt, der eine hohe mechanische Resonanzfrequenz besitzt, und einen Vibrationsabschnitt, der eine niedrigere mechanische Resonanzfrequenz besitzt.

Der Ausleger 2 vibriert aufgrund eines bimorph, thermischen Aktuators 50, der in dem Ausleger 2 integriert ist oder Teil des Auslegers 2 ist. Der Aufbau des bimorph, thermischen Aktuators 50 ist in Fig. 6 schematisch beschrieben. Ein überlagertes AC (Wechselstrom)- und DC (Gleichstrom)-Signal wird an die in Fig. 5 dargestellten Anschlüsse 19 und 20 angelegt. Die Wechselstromkomponente verursacht die Vibration des Auslegers und die Gleichstromkomponente liefert einen Heizstrom für das Heizelement 15, wodurch eine Verbiegung des Auslegers 2 erzeugt wird. Hinzu kommt, dass mit einer bestimmten Spannung ein bestimmter Abstand des Auslegers 2 zu der strukturierten Oberfläche 4 des Substrats 5 eingestellt werden kann. Der im Ausleger 2 vorgesehene bimorph, thermische Aktuator 50 besteht aus drei Schichten. Die erste Schicht 30 ist aus Silizium (Si), die zweite Schicht 32 ist aus Siliziumdioxid ($SiO_2$) und die dritte Schicht 34 ist aus Aluminium (Al). Die Bewegung des freien Endes 2a des Auslegers 2 kann durch die Gleichung (1) beschrieben werden.

$$z_T = 3K\Delta T l^2 \qquad \text{(Gleichung 1)}$$

wobei K durch die Gleichung 2 berechnet wird.

$$K = \frac{(\alpha_1 - \alpha_2)(d_1 + d_2)\frac{1}{t_2^2}}{4 + 6(\frac{d_1}{d_2}) + 4(\frac{d_1}{d_2})^2 + (\frac{d_1}{d_2})^3(\frac{E_1}{E_2}) + (\frac{d_2 E_2}{d_1 E_1})} \qquad \text{Gleichung 2}$$

Dabei ist d die Dicke des verwendeten Materials, l die Länge des Auslegers 2, E der Youngs Modul und $\alpha$ der thermische Ausdehnungskoeffizient eines im Ausleger 2 verwendeten Materials. Der nachstehenden Tabelle sind die E-Module und die thermischen Ausdehnungskoeffizienten der im Ausleger verwendeten Materialien zu entnehmen.

| Material | E-Modul (oder Youngscher Modul) | Thermischer Ausdehnungskoeffizient |
|---|---|---|
| Silizium (Si) | 170 GPa | $2.3 \times 10^{-6}$ 1/K |
| Siliziumdioxid ($SiO_2$) | 75 GPa | $0.4 \times 10^{-6}$ 1/K |
| Aluminium (Al) | 70 GPa | $23 \times 10^{-6}$ 1/K |

In der Gleichung (2) fließen nur die thermischen Ausdehnungskoeffizienten von Aluminium und Siliziumdioxid einen. Der Verzicht auf den thermischen Ausdehnungskoeffizienten führt in der Gleichung (2) zu einem vernachlässigbaren Fehler von ca. 3%.

Fig. 7 zeigt eine detaillierte Darstellung der Beschaltung des Auslegers 2 mit der Spannungsversorgungs- und Kontrolleinheit 24, die im einzelnen aus einer Stromquelle 60, einem Spannungsgenerator 61, eine Phasensperrschaltung 62 und eine PID-Kontrollschaltung 63. Wie oben erwähnt ist der Ausleger 2 mit dem Heizelement 15 versehen, das bei Bestromung durch den im Ausleger integrierten bimorph, thermischen Aktuator 50, zu einer Verbiegung des Auslegers 2 führt. Der Piezowiderstandssensor 14 besitzt die zwei Anschlüsse 21 und 22, die mit der Phasensperrschaltung 62 der Spannungsversorgungs- und Kontrolleinheit 24 verbunden sind. Die Phasensperrschaltung 62 empfängt die vom Piezowiderstandssensor 14 gemessene Spannung, die ein Maß für die Verbiegung des bimorph, thermischen Aktuators 50. Ebenso empfängt die Phasensperrschaltung 62 eine Spannung vom Spannungsgenerator 61, der in der Spannungsversorgungs- und Kontrolleinheit 24 integriert ist. Der Spannungsgenerator 61 liefert ein Wechselstromsignal $U_{AC}$ (siehe Gleichung 3)

$$U_{AC}(t) = U_0 \sin(\omega t) \qquad \text{Gleichung 3}$$

an die in der Stromquelle 60 vorgesehene Wechselstromquelle 64. Die Phasensperrschaltung 62 liefert ein Signal an die PID-Kontrollschaltung 63. Die. Die Stromquelle umfasst die Wechselstromquelle 64, die PID-Stromquelle 65 und eine Gleichstromquelle 66. Die Wechselstromquelle 64, die PID-Stromquelle 65 und die Gleichstromquelle 66 liefern deren jeweiliges Stromniveau an einen Addierer 67. Der Addierer 67 ist mit dem elektrischen Anschluss 19 für das Heizelement 15 verbunden. Der zweite elektrischen Anschluss 20 ist geerdet. Das Heizelement empfängt einen Strom wie in Gleichung 4 dargestellt.

$$I = I_{AC} + I_{DC} + I_{PID} \qquad \text{Gleichung 4}$$

Der Ausleger 2 wird durch den bimorph, thermischen Aktuator 50 mit der Resonanzfrequenz ($f_{RES}$) mit einer Wechselspannung, die der halben Resonanzfrequenz ($f_{RES}/2$) entspricht, angetrieben. Die Gleichspannung führt zu einer Auslenkung des Auslegers 2 senkrecht zu der zu strukturierenden Oberfläche 4. Der Abstand des Auslegers 2 zu der zu strukturierenden Oberfläche 4 wird durch PID- Kontrollschaltung 63 geregelt und auf ein gewünschtes Niveau eingestellt (P = Proportional, I = Integrator, D = Differentiator). Der Piezowiderstand 14 liefert ein Ausgangssignal, das an den elektrischen Anschlüssen 21 und 22 abgegriffen wird. Das Ausgangssignal wird mit diesem Spannungsniveau verglichen, das dem gewünschten Abstand zwischen der Nadelspitze 6 und der Oberfläche 4 des Substrats 5 entspricht. Falls der Abstand, der durch die Vibrationsfrequenz des Auslegers 2 bestimmt ist, außerhalb des Bereichs ist, wird ein Fehlersignal erzeugt. Das Fehlersignal wird dann an die PID- Kontrollschaltung 63 der Spannungsversorgungs- und Kontrolleinheit 24 geliefert, die die Gleichstromkomponente des Signals anpasst. Dies wiederum erzeugt so lange eine Änderung des Abstandes zwischen der Nadelspitze 6 und der Oberfläche 4 des Substrats 5, bis das Fehlersignal Null ist.

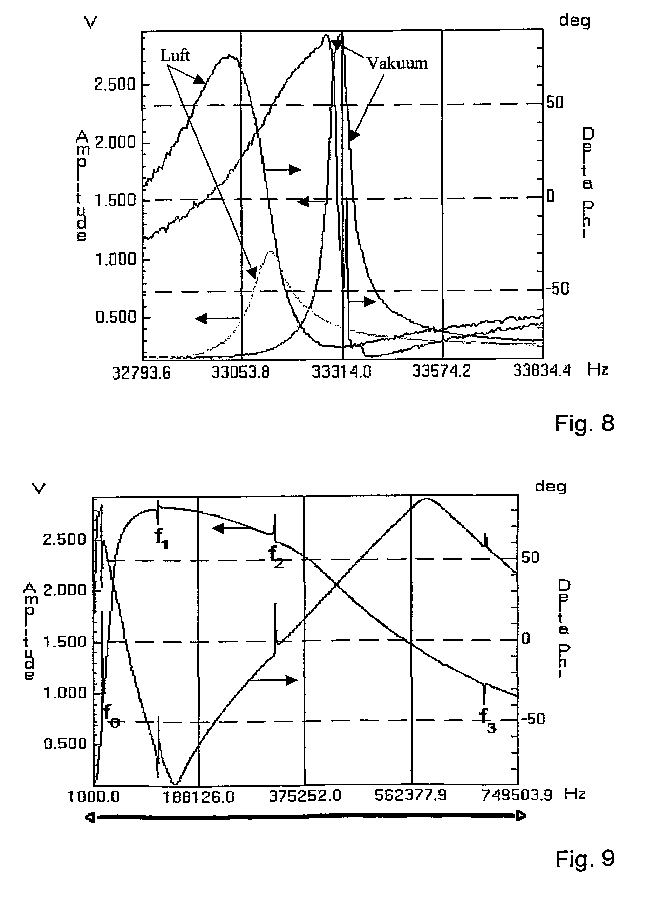

Fig. 8 ist eine graphische Darstellung der Resonanz und der Phasenverschiebung eines Auslegers sowohl im Vakuum als auch in Luft. Die erste Resonanz des Auslegers 2 in Luft zeigt gegenüber der eine Resonanz in Vakuum eine deutliche Verbreiterung um den Peak. Ferner ist die Lage des Peaks der Resonanz für den Ausleger in Luft zu einer niedrigeren Frequenz verschoben. Die deutliche Verbreiterung ist durch die Dämpfung der Luftmoleküle verursacht. Die Phasenverschiebung für den Ausleger 2 in Luft zeigt eine weniger scharfe Änderung der Phasenverschiebung im Bereich der Resonanzfrequenz als die Änderung der Phasenverschiebung für den Ausleger in Luft.

Fig. 9 ist eine Darstellung der mit dem Piezowiderstandssensor gemessenen Spannung als Funktion der Frequenz, mit der der Ausleger 2 vibriert. Bei der Darstellung aus Fig. 8 wird dabei die Frequenz von der Grundresonanzfrequenz $f_0$ bis über den dritten Eigenmode $f_3$ hinaus gescannt. Die Grundresonanzfrequenz $f_0$, der erste Eigenmode $f_1$, der zweite Eigenmode $f_2$ und der dritte Eigenmode $f_3$ zeichnen sich in der Funktion der Amplitude als scharfe Peaks aus. Den Peaks der Eigenmoden sind in der Funktion für die Phasenverschiebungen korrespondierende Peaks zugeordnet. Bei höheren Eigenmoden kann eine höhere Geschwindigkeit bei der Bearbeitung der zu strukturierenden Oberfläche 4 erzielt werden. Ebenso ist bei höheren Eigenmoden eine größere Empfindlichkeit und eine größere Kraftauflösung gegeben.

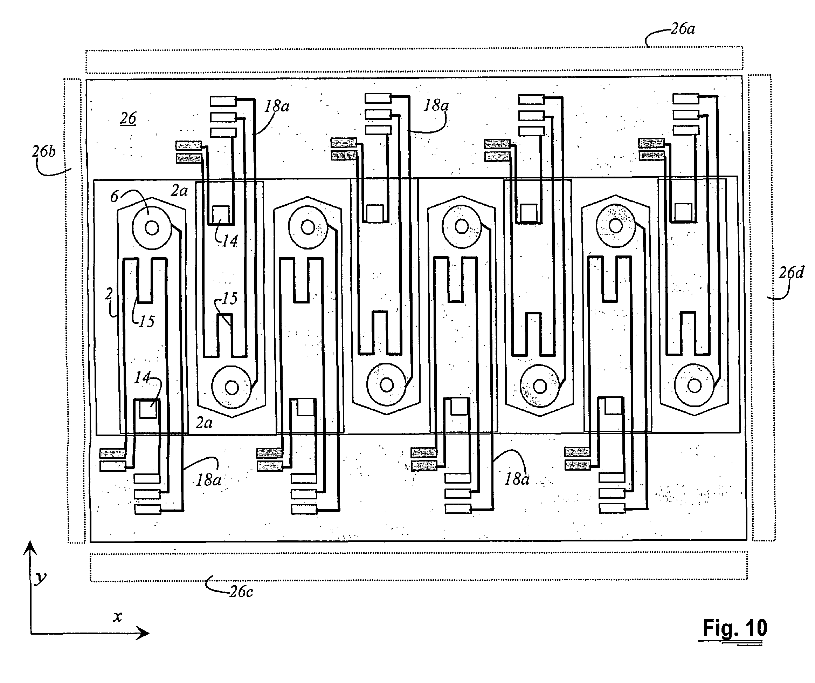

Wie in Fig. 10 dargestellt ist, besteht die Vorrichtung zur maskenlosen Mikrolithographie aus einem Array 26 in dem die Ausleger 2 angeordnet sind. Das Array 26 wird aus Silizium hergestellt und mit einem mikrostrukturierenden Herstellungsverfahren gefertigt. Gemäß dieser bevorzugten Ausführungsform, ist das Array 26 der Ausleger 2 in einem ersten Wafer ausgebildet, der die gleiche Größe besitzt wie ein zweiter Wafer, im dem ein Muster aufgebracht werden soll. Um die gesamte Fläche des ersten Wafers zu überdecken, sind mehrere Arrays 26a, 26b, 26c, 26d,... mosaikartig auf der Oberfläche des ersten Wafers angeordnet. In Fig. 10 sind die mehreren Arrays 26a, 26b, 26c, 26d,... als gestrichelte Rahmen dargestellt. In einen zweiten Wafer soll mittels des lithographischen Verfahrens mit ein Muster eingebracht werden. Der erste und der zweite Wafer enthalten jeweils Halbleitergebiete, die kongruent zueinander sind. Wie bereits oben erwähnt, werden die Ausleger 2 in einer oder mehreren Reihen in jedem der Halbleitergebiete des ersten Wafers ausgebildet. Der erste und der zweite Wafer werden dann mit dem "Gesicht" zueinander zusammengebracht. Dies bedeutet, dass sich die Nadelspitzen 6 der Ausleger 2 des ersten Wafers nahe zur Oberfläche 4 des zweiten Wafers befinden, wobei dieser zur Bemusterung durch von den individuellen Nadelspitzen 6 der Ausleger 2 austretenden Elektronen ausgewählt ist. Der zweite Wafer, der bestrahlt bzw. bemustert werden soll, wird dann in einer scannenden Art

6

und Weise abgescannt und zwar derart, dass die Nadelspitzen 6 der Ausleger 2 des ersten Wafers die gesamte Oberfläche des zweiten Wafers beschreiben können und überdecken. Dies kann geschehen, wenn zwischen dem ersten und dem zweiten Wafer zum Erzeugen der scannenden Bewegung eine Relativbewegung ausgeführt wird. Im Falle eines Wafers mit 200 mm Durchmesser und bei einer Dichte der Nadelspitzen 6 von 20 Nadelspitzen/mm$^2$, sollten 600.000 einzelne Nadelspitzen in der mosaikartigen Anordnung der Arrays aktiv sein. Wohingegen die gesamte Bewegung des darunter liegenden zweiten Wafers während des Bestrahlungsprozesses etwa nur 1 mm in der x- und der y-Richtung beträgt.

Eine andere mögliche Anordnung der Ausleger 2 kann in einem schmalen Streifen begründet sein. Die in Reihe angeordneten einzelnen Ausleger 2 bilden somit einen Streifen, der sich zum Beispiel über den gesamten Durchmesser des zu bestrahlenden oder zu strukturierenden Wafers (dem zweiten Wafer) erstreckt. Während der Bestrahlung des Wafers vollzieht der Streifen zusätzlich eine weit reichende Bewegung, um somit während der Bestrahlung die gesamte Fläche des zweiten Wafers zu überstreichen. Eine weitere mögliche Anordnung wäre ein kleines quadratisches Segment (ein flächige Anordnung von mehreren Auslegern 2). Das Segment ist weitaus kleiner als der zu beschreibende zweite Wafer. Um den gesamten zweiten Wafer zu beschreiben, muss das Segment über größere Entfernungen entlang der x- und y-Koordinaten bewegt und kontrolliert werden.

Die Nadelspitzen 6 der Ausleger 2 können z.B. dahingehend benutzt werden, um über die Leiterbahn 18a ein starkes Feld an jede Nadelspitze 6 in der Anordnung der Arrays 2 anzulegen. Wenn Wasserdampf vorhanden ist, so kommt es zu einer Oxidation der obersten Schicht des zweiten Wafers. Die oberste Schicht oder Oberfläche des zweiten Wafers besteht zum Beispiel aus Silizium oder Chrom oder Titan.

Ferner kann jede Nadelspitze 6 in der Anordnung der Arrays 24 benutzt werden, um das gewünschte Muster in eine Schicht aus weichen Material zu schreiben. Eine solche Schicht besteht z.B. aus einem dünnen Film aus Polymethyl- metacrylat (PMMA).

In einer weiteren Anwendung ist es notwendig die Neutralposition der Ausleger 2 genau zu regeln. In Anbetracht, dass es Wellungen und/oder eine Topographie auf der Oberfläche des zweiten Wafers gibt, sind die Ausleger 2 derart ausgestaltet, dass sie sich um ein gewisses Maß biegen können.

Mit der Vorrichtung kann ein Verfahren durchgeführt werden, das die maskenlose Elektronenstrahllithographie auf einem Substrat bzw. einem Wafer mit z.B. einer Schicht aus einem Resist ermöglicht. Hierzu wird mindestens ein Array 24 von Auslegern 2 zur Verfügung gestellt, wobei am festen Basisteil 16 der Piezowiderstandssensor 14 vorgesehen ist. Der Ausleger 2 ist in einem Siliziumwafer ausgebildet und jeder der Ausleger 2 verfügt über eine Nadelspitze 6 zur gattergesteuerten Feldemission, wobei die Nadelspitze 6 in der Nähe des freien Endes 2a des Auslegers 2 vorgesehen ist. Wie bereits in Fig. 5 beschrieben ist, ist im Ausleger der bimorph, thermischer Aktuator 50 integriert. Die Ausleger 2 und der zweite Wafer oder Substrat, das den Resist umfasst, werden zusammengebracht, wobei die Nadelspitzen 6 der Ausleger 2 der zu strukturierenden Oberfläche 4 auf dem Substrat 5 (Wafer) gegenüberliegt. Die Oberfläche kann z.B. aus einer Schicht eines Resists gebildet sein. Zum Schreiben in der Oberfläche 4 wird das Array 24 der Ausleger 2 über die Oberfläche 4 des Substrats 5, das z.B. den Resist trägt, gescannt. Das schrittweise Scannen kann derart ausgestaltet sein, dass der die Ausleger 2 tragende erste Wafer und der den Resist tragende zweite Wafer entlang einer ersten Achse hin und her oszillieren. Die erste Achse ist z.B. die y-Achse eines kartesischen Koordinatensystems. Der erste, die Ausleger tragende Wafer und der den Resist tragende zweite Wafer werden entlang einer x-Achse fortbewegt, die im Allgemeinen senkrecht zur y-Achse ist. Zwischen der Nadelspitze 6 der Ausleger 2 und dem den Resist tragenden zweiten Wafer fließt ein Feldelektronenstrom, der entsprechend dem auf dem zweiten Wafer herzustellenden Muster gesteuert unterbrochen werden kann. Die Schicht des Resists auf dem zweiten Wafer wird mit einer Vielzahl von ausgewählten lithographischen Mustern durch den Elektronenstrahl der Feldemission belichtet.

Während des Scannens sind die Nadelspitzen 6 für die Feldemission in der Nähe zur Oberfläche 4 des Substrats 5 bzw. des zweiten Wafers, der den Resist trägt. Damit sich die Ausleger 2 oder zumindest die freien Enden 2a der Ausleger 2 der Oberfläche 4 nähern erfolgt ein Verbiegen der Ausleger 2 und ein Bestimmen der jeweiligen wechselwirkenden Kräfte, um den Abstand zur Oberfläche zu kontrollieren und zu steuern. Hierzu wird eine piezoresitive Detektion verwendet.

Das Vibrieren der Ausleger 2 wird durch Anlegen einer Wechselspannung an ein thermisch, bimorphes Betätigungselement erreicht, das jedem Ausleger 2 zugeordnet ist. Die mit dem Piezowiderstand 14 detektierte Vibrationsfrequenz eines jeden Auslegers 2 dient zum Anpassen des Abstandes zwischen der Nadelspitze 6 des Auslegers 2 und der Oberfläche 4 des Substrats 5. Die Oszillationen bzw. die Richtung des Vibrierens der einzelnen Ausleger 2 ist senkrecht zu der zu bemusternden oder strukturierenden Oberfläche 4 eines Substrats 5 oder eines Wafers. Die Oszillationen der Ausleger 2 werden mittels des Piezowiderstandes 14, der im Ausleger 2 eingebettet ist, derart detektiert, dass sich deren Widerstand mit jeder Biegung des Auslegers 2 ändert. Der Widerstand des Piezowiderstandes 14 wird bestimmt und stellt ein Signal zur Verfügung, das auf die Resonanzfrequenz des Auslegers 2 hindeutet, wobei ein Rückkopplungssystem verwendet wird, um den Abstand zwischen der Nadelspitze 6 und der Oberfläche 4 des Resists oder der Oberfläche 4 Substrats 5 zu regeln.

Man lässt die Ausleger 2 vibrieren, um den Abstand anzupassen. Dazu wird den Auslegern 2 ein Wechselspannungs-/Gleichspannungssignals in einem thermisch, bimorphen Aktuatorelement überlagert, das an dem Ausleger 2 angebracht ist. Die Widerstandsmessung ist an den Widerstand des Piezowiderstandes 14 gekoppelt, um den Widerstand zu messen und ein Signal zu erzeugen, das den Oszillationen der Ausleger 2 entspricht. Das bimorphe Aktuatorelement wird zum Erzeugen der Oszillationen der Ausleger 2 verwendet.

An jeder Nadelspitze 6 wird eine elektrische Vorspannung zur Feldemission angelegt. Anschließend erfolgt ein Unterbrechen des elektrischen Feldes. Das entsprechend der zuschreibenden Daten wird das elektrische Feld in entsprechender Weise angeschaltet und unterbrochen, wodurch die Resistschicht veranlasst wird eine Vielzahl von entworfenen lithographischen Mustern in einem Medium auf der Oberfläche 4 des Substrats 5 auszubilden.

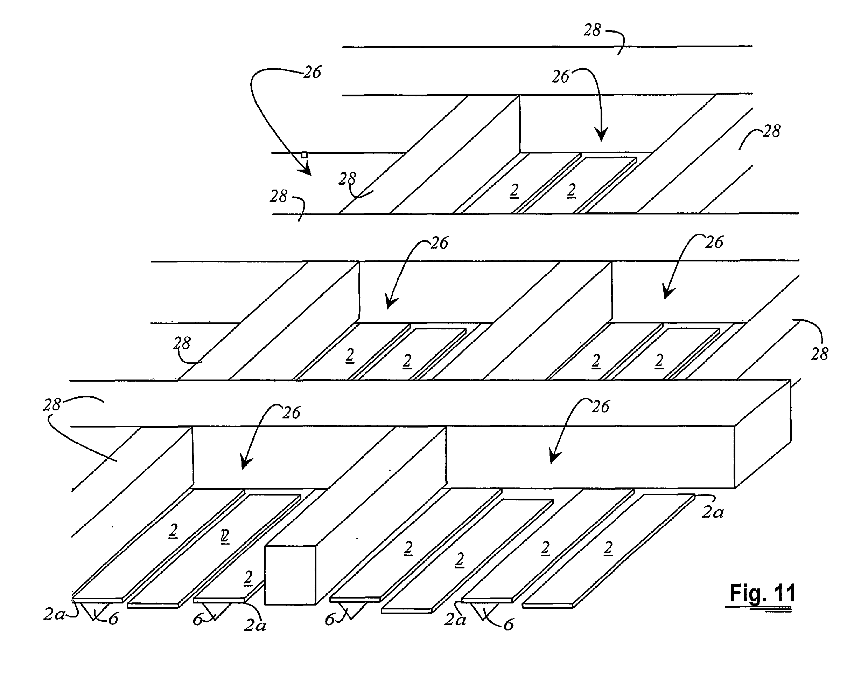

Fig. 11 zeigt eine perspektivische Teilansicht einer Anordnung von mehreren Arrays 26 in einem hoch auflösenden / mikrolithographischen Systems in, auf oder von einem Silizium Wafer hergestellt. Die einzelnen Arrays sind durch Stege 28 des Silizium-Wafers von einander getrennt. Jeder Ausleger 2 umfasst einen gittergesteuerten Emitter für die Feldemission (Quelle für Elektronen mit einem sehr engem Energieband) in der Nähe des freien Endes 2a des Auslegers 2. Der gattergesteuerte Feldemitter ist eine Nadelspitze 6. Jeder gattergesteuerte Feldemitter ist über Durchgänge 29 in den Stegen 28 des Wafers elektrisch mit einer Spannungsversorgungs- und Kontrolleinheit 24 verbunden.

Die Anordnung des Arrays 26 der Ausleger 2, und mit den auf den Auslegern integral ausgeformten gattergesteuerten Emittern für die Feldemission, ist über dem zweiten Wafer (Substrat) angeordnet, der durch die von den Emittern austretenden Elektronen bemustert werden muss.

Die Anordnung des Arrays der Ausleger 2 wird über den zweiten Wafer (Substrat) verfahren, wobei ein Adressgitter von 1 nm oder kleiner verwendet wird. Bevorzugter Weise erfolgt das Verfahren in einer einem Raster ähnlichen Art und Weise. Die individuelle Spannungsversorgungs- und Kontrolleinheit 24 werden derart betrieben, dass der Strom der Feldemission oder das elektrische Feld an der Nadelspitze 6 für die gattergesteuerte Feldemission eines Auslegers 2 mit einer hohen Frequenz (2-10 MHz) kontrolliert wird.

Die durch Feldemission freigesetzten Elektronen werden verwendet, um ein Muster in einen für Elektronen empfindlichen Resist zu schreiben, der auf der Oberfläche 4 des Substrats 5 aufgebracht ist (im Falle der herkömmlichen Maskenlithographie) oder direkt auf der Oberfläche des Wafers selbst (im Falle der maskenlosen Lithographie).

Mit einem Ausleger 6, der mit einer Frequenz von 2 MHz schwingt und einer Scangeschwindigkeit von 100 mm/s, kann eine Fläche von 1mm$^2$ in 200 Sekunden bemustert werden.

Mit einer Anordnung von 20 Proben pro mm$^2$ kann eine Fläche von 1mm$^2$ in 10 Sekunden beschrieben werden. Werden 10000 Ausleger in einem Array verwendet, ist es möglich einen 200 mm Wafer mit einer Fläche von 3x10$^4$ mm$^2$ mit einer Schreibdauer von 10 Minuten zu bemustern.

Falls die gittergesteuerte Feldemission mit einem hohen Strom verwendet wird, was es ermöglicht mit einer veränderbaren Spotgröße (z.B. 30 bis 150 nm$^2$) zu arbeiten, wird die Schreibdauer (oder die Anzahl der schreibenden Ausleger) pro Wafer erheblich reduziert werden können.

Die Erfindung wurde in Bezug auf eine besondere Ausführungsform beschrieben. Es ist einem Fachmann jedoch klar, das Abwandlungen und Modifikationen durchgeführt werden können, ohne den Schutzbereich der Ansprüche zu verlassen.

Bezugszeichenliste:

| | |
|---|---|
| 2 | Ausleger |
| 2a | freies Ende |
| 4 | Oberfläche |
| 5 | Substrat |
| 6 | Nadelspitze |
| 8 | Struktur |
| 10 | Spitze |
| 12 | Ring |
| 14 | Piezowiderstandssensor |
| 15 | Heizelement |
| 16 | Basisteil |
| 18 | Anschluss |
| 18a | Leiterbahn |
| 19 | Anschluss |
| 19a | Leiterbahn |

(fortgesetzt)

| 20 | Anschluss |
|----|-----------|
| 21 | Anschluss |
| 22 | Anschluss |
| 24 | Spannungsversorgungs- und Kontrolleinheit |
| 26 | Array |
| 28 | Stege |
| 29 | Durchgänge |
| 30 | erste Schicht |
| 32 | zweite Schicht |
| 34 | dritte Schicht |
| 40 | erste Kurve |
| 41 | zweite Kurve |
| 50 | bimorph, thermischer Aktuator |
| 60 | Stromquelle |
| 61 | Spannungsgenerator |
| 62 | Phasensperrschaltung |
| 63 | PID-Kontrollschaltung |
| 64 | Wechselstromquelle |
| 65 | PID-Stromquelle |
| 66 | Gleichstromquelle |
| 67 | Addierer |

**Patentansprüche**

1. Vorrichtung zur maskenlosen Elektronenstrahl-Mikrolithographie an einer zu strukturierenden Oberfläche eines Substrats, Wobei die Vorrichtung eine Vielzahl mikrostrukturierter Ausleger (2), die an einem freien Ende (2a) jeweils eine Nadelspitze (6) tragen, umfasst, mehrere mikrostrukturierte Ausleger (2) in einem Array (26) angeordnet sind, jeder Ausleger (2) des Arrays (26) einen bimorph, thermischen Aktuator (50), einen Piezowiderstandssensor (14) und ein Heizelement (15) enthält, für jeden Ausleger eine Spannungsversorgungs-und Kontrolleinheit (24) vorgesehen ist, die mit der Nadelspitze (6), dem Heizelement (15) und dem Piezowiderstandssensor (14) verbunden ist, die Nadelspitze (6) und das Heizelement (15) geeignet bestromt und die am Piezowiderstandssensor (14) erzeugte Spannung empfängt, die Nadelspitze (6) aus einer Spitze (10) und einem Ring (12) aufgebaut ist, wobei zwischen dem Ring (12) und der Spitze (10) eine Kathodenspannung $V_k$ anlegbar ist wobei, die als Stand-by Spannung wirkt, und über das Verhältnis der Kathodenspannung $V_k$ und einer Anodenspannung $V_a$ zwischen Nadelspitze und Substratoberfläche, eine Spotgröße eines Elektronenstrahls (E) auf einer zu strukturierenden Oberfläche (4) regelbar ist.

2. Vorrichtung nach Anspruch 1, wobei die Spannungsversorgungs-Vorrichtung und Kontrolleinheit (24) aus einer Stromquelle (60), einem Spannungsgenerator (61), einer Phasensperrschaltung (62) und einer PID-Kontrollschaltung (63) aufgebaut ist, wobei die Stromquelle (60) eine Wechselstromquelle (64), eine PID-Stromquelle (65) und eine Gleichstromquelle (66) umfasst.

3. Vorrichtung nach Anspruch 2, wobei die Phasensperrschaltung (62) die vom Piezowiderstandssensor (14) gemessene Spannung und eine Spannung vom Spannungsgenerator (61) empfängt, die Phasensperrschaltung (62) ein Signal an die PID-Kontrollschaltung (63) liefert, die PID-Kontrollschaltung (63) wiederum ein Signal an die PID-Stromquelle (65), die in der Stromquelle (60) vorgesehen ist, liefert, und der Spannungsgenerator (61) ein Wechselstromsignal an die Wechselstromquelle (64), die in der Stromquelle (60) vorgesehen ist, liefert.

4. Vorrichtung nach Anspruch 2, wobei in der Stromquelle (60) ein Addierer (67) vorgesehen ist, der den Strom der Wechselstromquelle (64), den Strom der PID-Stromquelle (65) und den Strom der Gleichstromquelle (66) zusammenführt, und der über einen elektrischen Anschluss (19) mit dem Heizelement (15) verbunden ist.

5. Vorrichtung nach Anspruch 1, wobei über die Spannungsversorgungs- und Kontrolleinheit (24) eine Phasenverschiebung des Auslegers (2) bestimm bar ist und dass mittels die Spannungsversorgungs-und Kontrolleinheit (24) den Abstand zwischen der Nadelspitze (6) und der zu strukturierenden Oberfläche (4) des Substrats (5) anpass bar ist und konstant hält bar ist wobei die Phasenverschiebung bei einer konstanten Größe gehalten ist.

**6.** Vorrichtung nach Anspruch 1, wobei die zu strukturierende Oberfläche (4) die Oberfläche eines Wafers darstellt, die mit einer Schicht eines zu strukturierenden Mittels belegt ist.

**7.** Vorrichtung nach Anspruch 5, wobei die Anordnung der Ausleger (2) in einem Array (26) als eine Reihe ausgebildet ist, und dass die Länge der Reihe etwa dem Durchmesser des Wafers entspricht, der die zu strukturierende Schicht trägt.

**8.** Vorrichtung nach Anspruch 5, die Anordnung der Ausleger (2) in dem Array (26) als eine flächige Matrixanordnung ausgebildet ist.

**9.** Vorrichtung nach Anspruch 8, mehrere flächige Matrixanordnungen der Ausleger (2) in dem Array (26) mosaikartig angeordnet sind, und die mosaikartige Anordnung etwa der Fläche der zu strukturierenden Oberfläche (4) des Wafers oder Substrats entspricht.

**10.** Vorrichtung nach einem der Ansprüche 1 bis 9, der Ausleger (2) mit strukturierten Leitungen (18a und 19a) zur Steuerung und Kontrolle des Auslegers (2) versehen ist, und jeder Ausleger (2) mit einem Basisteil (16) versehen ist, auf dem mehrere elektrische Anschlüsse (19, 20, 21, 22) strukturiert sind.

**11.** Vorrichtung nach einem der Ansprüche 1 bis 10, der bimorph, thermische Aktuator (50) aus drei Schichten aufgebaut ist, wobei eine erste Schicht (30) aus Silizium (Si), eine zweite Schicht (32) aus Siliziumdioxid ($SiO_2$) und eine dritte Schicht (34) aus Aluminium (Al) besteht.

**12.** Vorrichtung nach Anspruch 1, eine Anordnung von mehreren Arrays (26) in einem Silizium-Wafer ausgebildet ist, wobei die einzelnen Arrays (26) durch Stege (28) aus Silizium voneinander getrennt sind, und über Durchgänge (29) in den Stegen die Verbindung zur Spannungsversorgungs-und Kontrolleinheit (24) hergestellt ist.

**13.** Verfahren zur maskenlosen Mikrolithographie mit einer Vorrichtung nach einer der Ansprüche 1-12, das die folgenden Schritte umfasst:

- Zusammenbringen mindestens eines Arrays (26) mit Auslegern (2), von denen jeder eine Nadelspitze (6) trägt, mit einer zu strukturierenden Oberfläche (4) derart, dass die Nadelspitzen (6) nahe der zu strukturierenden Oberfläche (4) angeordnet sind,
- Bestimmen einer Phasenverschiebung der Ausleger (2) in den Arrays (26) mit einer Spannungsversorgungs- und Kontrolleinheit (24), und Regelung eines Abstands zwischen der an jedem Ausleger (2) vorgesehenen Nadelspitze (6) und der zu strukturierenden Oberfläche (4) auf einen konstanten Wert mit der Spannungsversorgungs- und Kontrolleinheit (24), wobei die Phasenverschiebung der Ausleger (2) als Maß für den Abstand dient,
- Ausführen einer Relativbewegung zwischen dem mindestens einen Array (26) mit Auslegern (2) und der zu strukturierenden Oberfläche (4),
- Anlegen einer elektrischen Anodenspannung $V_a$ an die Nadelspitze (6), um dadurch ein elektrisches Feld zwischen der Nadelspitze und der zu strukturierenden Oberfläche (4) auszubilden,
- Einstellen der Kathodenspannung $V_k$ und der Anodenspannung $V_a$, um durch das Verhältnis der Kathodenspannung $V_k$ zur Anodenspannung $V_a$ die Spotgröße des Elektronenstrahls (E) auf der zu strukturierenden Oberfläche (4) zu regeln,
- Steuern der Spannung in Abhängigkeit des auf der zu strukturierenden Oberfläche (4) zu erzeugenden Musters.

**14.** Verfahren gemäß Anspruch 13, wobei der Abstand der Nadelspitze (6) des Auslegers (2) zu der zu strukturierenden Oberfläche (2) mittels eines im Ausleger (2) vorgesehenen Heizelements (15) durch Bestromung verändert wird, wobei im Ausleger (2) ein bimorph, thermischer Aktuator (50) integriert ist.

**15.** Verfahren gemäß Anspruch 13, wobei die Spannungsversorgungs- und Kontrolleinheit (24) aus einer Stromquelle (60), einem Spannungsgenerator (61), einer Phasensperrschaltung (62) und einer PID-Kontrollschaltung (63) aufgebaut ist, wobei die Stromquelle (60) eine Wechselstromquelle (64), eine PID-Stromquelle (65) und eine Gleichstromquelle (66) umfasst.

16. Verfahren gemäß Anspruch 13, wobei die Phasensperrschaltung (62) die vom Piezowiderstandssensor (14) gemessene Spannung und eine Spannung vom Spannungsgenerator (61) empfängt, die Phasensperrschaltung (62) ein Signal an die PID-Kontrollschaltung (63) liefert, die PID-Kontrollschaltung (63) wiederum ein Signal an die PID-Stromquelle (65) liefert, und der Spannungsgenerator (61) ein Wechselstromsignal an die Wechselstromquelle (64) liefert.

17. Verfahren gemäß Anspruch 14, wobei dem Heizelement (15) über einen Addierer (67) in der Stromquelle (60) der Strom der Wechselstromquelle (64), der Strom der PID-Stromquelle (65) und der Strom der Gleichstromquelle (66) zugeführt wird.

18. Verfahren gemäß Anspruch 13, wobei über die Spannungsversorgungs-und Kontrolleinheit (24) die Phasenverschiebung des Auslegers (2) bestimmt wird, und wobei über die Spannungsversorgungs-und Kontrolleinheit (24) der Abstand zwischen der Nadelspitze (6) und der zu strukturierenden Oberfläche (4) des Substrats (5) angepasst und konstant gehalten wird, wobei die Phasenverschiebung bei einer konstanten Größe gehalten wird.

19. Verfahren gemäß Anspruch 13, wobei das Anlegen der elektrischen Spannung an die Nadelspitze (6) mittels der Spannungsversorgungs-und Kontrolleinheit (24) durchgeführt wird.

20. Verfahren gemäß Anspruch 19, wobei die individuelle Spannungsversorgungs-und Kontrolleinheit (24) derart betrieben wird, wobei an das Heizelement (15) eine derartige Wechselspannung angelegt wird, dass die Ausleger (2) in einem Frequenzbereich von 1-15 MHz zum Schwingen angeregt werden.

21. Verfahren gemäß Anspruch 20, wobei in dem Frequenzbereich mit dem die Ausleger (2) schwingen die Resonanzfrequenz und mindestens drei Eigenmoden der Ausleger (2) liegen.

**Claims**

1. A device for maskless electron beam microlithography at a surface of a substrate to be structured, wherein the device comprises a plurality of micro-structured extension arms (2) which each carry a needle point (6) at a free end (2a), a plurality of micro-structured extension arms (2) are arranged in an array (26), each extension arm (2) of the array (26) contains a bimorphic thermal actuator (50), a piezoresistance sensor (14) and a heating element (15), a power supply and control unit (24) is provided for each extension arm, which power supply and control unit (24) is connected with the needle point (6), the heating element (15) and the piezoresistance sensor (14), suitably supplies power to the needle point (6) and the heating element (15) and receives the voltage generated at the piezoresistance sensor (14), the needle point (6) is constructed from a point (10) and a ring (12), wherein a cathode voltage $V_k$ can be applied between the ring (12) and the point (10), which operates as a stand-by voltage, and wherein a spot size of an electron beam (E) can be regulated on a surface to be structured (4) by the ratio of the cathode voltage $V_k$ to an anode voltage $V_a$ between the needle point and the substrate surface.

2. The device according to Claim 1, wherein the power supply and control unit (24) is constructed from a current source (60), a voltage generator (61), a phase inhibition circuit (62) and a PID control circuit (63), wherein the current source (60) comprises an alternating current source (64), a PID power source (65) and a direct current source (66).

3. The device according to Claim 2, wherein the phase inhibition circuit (62) receives the voltage measured by the piezoresistance sensor (14) and a voltage from the voltage generator (61), the phase inhibition circuit (62) delivers a signal to the PID control circuit (63), the PID control circuit (63) in turn delivers a signal to the PID control circuit (65) which is provided for in the power source (60), and the voltage generator (61) delivers an AC signal to the alternating current source (64) which is provided in the power source (60).

4. The device according to Claim 2, wherein an adder (67) is provided for in the power source (60) which brings together the current from the alternating current source (64), the current from the PID power source (65) and the current from the direct current source (66) and which is connected with the heating element (15) through an electrical connection (19).

5. The device according to Claim 1, wherein a phase shift of the extension arm (2) is determinable over the power supply and control unit (24), and the distance between the needle point (6) and the surface (4) of the substrate (5) to be structured is adaptable and can be held constant by means of the power supply and control unit (24), wherein the phase shift is held at a constant level.

6. The device according to Claim 1, wherein the surface (4) of the substrate (5) to be structured is the surface of a wafer, which is covered by a layer of a means to be structured.

7. The device according to Claim 5, wherein the arrangement of the extension arms (2) in an array (26) is formed as a row and the length of the row is roughly the diameter of the wafer, which carries the layer to be structured.

8. The device according to Claim 5, wherein the arrangement of the extension arms (2) in the array (26) is formed as a planar matrix array.

9. The device according to Claim 8, wherein a plurality of planar matrix arrays of the extension arms (2) are arranged in the array (26) as a mosaic and the mosaic-like arrangement roughly represents the area of the surface (4) of the wafer or the substrate to be structured.

10. The device according to any one of the claims 1 to 9, wherein the extension arm (2) is fitted with structured lines (18a and 19a) for controlling and checking the extension arm (2) and each extension arm (2) is fitted with a base part (16), on which a plurality of electrical connections (19, 20, 21, 22) are structured.

11. The device according to any one of the claims 1 to 10, wherein the bimorphic thermal actuator (50) is formed from three layers, wherein a first layer (30) consists of silicon (Si), a second layer (32) of silicon dioxide ($SiO_2$) and a third layer (34) of aluminum (Al).

12. The device according to Claim 1, wherein an arrangement of a plurality of arrays (26) is formed in a silicon wafer, wherein the individual arrays (26) are separated from each other by ribs (28) made out of silicon and the connection to the power supply and control unit (24) is created via passageways (29) in the ribs.

13. A method for maskless microlithography with a device according to any one of the claims 1-12, which comprises the following steps:

- bringing together of at least one array (26) with extension arms (2) of which every one carries a needle point (6), with a surface (4) to be structured, in such a way that the needle points (6) are arranged close to the surface (4) to be structured,
- determination of a phase shift of the extension arms (2) in the arrays (26) with a power supply and control unit (24), and regulation of a distance between the needle point (6) provided for at every extension arm (2) and the surface (4) to be structured at a constant value by means of the power supply and control unit (24), wherein the phase shift of the extension arms (2) serves as a measure of the distance,
- execution of a relative movement between the at least one array (26) with extension arms (2) and the surface (4) to be structured,
- application of an electrical anode voltage $V_a$ to the needle point (6) in order to produce an electrical field between the needle point and the surface (4) to be structured,
- adjustment of the cathode voltage $V_k$ and the anode voltage $V_a$ in order to regulate the spot size of the electron beam (E) on the surface (4) to be structured based on the ratio of the cathode voltage $V_k$ to the anode voltage $V_a$,
- controlling the voltage depending on the pattern to be generated on the surface (4) to be structured.

14. The method according to Claim 13, wherein the distance of the needle point (6) of the extension arm (2) to the surface (4) to be structured is modified by means of passing a current through a heating element (15) in the extension arm (2), wherein a bimorphic thermal actuator (50) is integrated in the extension arm (2).

15. The method according to Claim 13, wherein the power supply and control unit (24) is constructed from a power source (60), a voltage generator (61), a phase inhibition circuit (62) and a PID control circuit (63), wherein the power source (60) comprises an alternating current source (64), a PID power source (65) and a direct current source (66).

16. The method according to Claim 13, wherein the phase inhibition circuit (62) receives the voltage measured by the piezoresistance sensor (14) and a voltage from the voltage generator (61), the phase inhibition circuit (62) delivers a signal to the PID control circuit (63), the PID control circuit (63) in turn delivers a signal to the PID control circuit (65) and the voltage generator (61) delivers an AC signal to the alternating current source (64).

**17.** The method according to Claim 14, wherein the current from the alternating current source (64), the current from the PID power source (65) and the current from the direct current source (66) are brought together to the heating element (15) via an adder (67) in the power source (60).

**18.** The method according to Claim 13, wherein the phase shift of the extension arm (2) is determined by means of the power supply and control unit (24) and the distance between the needle point (6) and the surface (4) of the substrate (5) to be structured is adapted and held constant by means of the power supply and control unit (24), wherein the phase shift is kept at a constant level.

**19.** The method according to Claim 13, wherein the application of the electrical voltage to the needle point (6) is performed by means of the power supply and control unit (24).

**20.** The method according to Claim 19, wherein the individual power supply and control unit (24) is run in such a way and such an AC voltage is applied to the heating element (15) that the extension arms (2) are induced to oscillate in a frequency range of 1-15 MHz.

**21.** The method according to Claim 20, wherein the resonant frequency and at least three individual modes of the extension arms (2) are in the frequency range in which the extension arms (2) oscillate.

**Revendications**

**1.** Dispositif pour la microlithographie par faisceaux d'électrons sans masque sur une surface d'un substrat à structurer, étant donné que le dispositif comprend une pluralité d'avant-bras (2) microstructurés qui portent respectivement à une extrémité libre (2a) une pointe d'aiguille (6), une pluralité d'avant-bras (2) microstructurés sont disposés dans un ensemble (26), chaque avant-bras (2) de l'ensemble (26) contient un actionneur (50) thermique bimorphe, un capteur piézorésistif (14) et un élément chauffant (15), une unité d'alimentation électrique et de contrôle (24) est prévue pour chaque avant-bras, unité d'alimentation et de contrôle (24) qui reliée à la pointe d'aiguille (6), à l'élément chauffant (15) et au capteur piézorésistif (14), alimente en courant la pointe d'aiguille (6) et l'élément chauffant (15) de manière appropriée et reçoit la tension générée au capteur piézorésistif (14), la pointe d'aiguille (6) se compose d'une pointe (10) et d'un anneau (12), étant donné que peut être appliquée entre l'anneau (12) et la pointe (10) une tension de cathode $V_k$ qui agit comme tension de veille, et étant donné que, par l'intermédiaire du rapport de la tension de cathode $V_k$ et une tension d'anode $V_a$ entre la pointe d'aiguille et la surface du substrat, une taille de point d'un faisceau d'électrons (E) peut être ajusté sur une surface (4) à structurer.

**2.** Dispositif selon la revendication 1, étant donné que l'unité d'alimentation électrique et de contrôle (24) se compose d'une source de courant (60), un générateur de tension (61), un circuit de blocage de phase (62) et un circuit de contrôle PID (63), étant donné que la source de courant (60) comprend une source de courant alternatif (64), une source de courant PID (65) et une source de courant continu (66).

**3.** Dispositif selon la revendication 2, étant donné que le circuit de blocage de phase (62) reçoit la tension mesurée par le capteur piézorésistif (14) et une tension du générateur de tension (61), le circuit de blocage de phase (62) fournit un signal au circuit de contrôle PID (63), le circuit de contrôle PID (63) pour sa part fournit un signal à la source de courant PID (65) qui est prévue dans la source de courant (60), et le générateur de tension (61) fournit un signal de courant alternatif à la source de courant alternatif (64) qui est prévue dans la source de courant (60).

**4.** Dispositif selon la revendication 2, étant donné qu'est prévu dans la source de courant (60) un additionneur (67) qui combine le courant de la source de courant alternatif (64), le courant de la source de courant PID (65) et le courant de la source de courant continu (66), et qui est relié par l'intermédiaire d'un raccord électrique (19) à l'élément chauffant (15).

**5.** Dispositif selon la revendication 1, étant donné qu'un décalage de phase de l'avant-bras (2) peut être déterminé par l'intermédiaire de l'unité d'alimentation électrique et de contrôle (24) et la distance entre la pointe d'aiguille (6) et la surface à structurer (4) du substrat (5) peut être adaptée et maintenue constante au moyen de l'unité d'alimentation électrique et de contrôle (24), étant donné que le décalage de phase est maintenu à une valeur constante.

**6.** Dispositif selon la revendication 1, étant donné que la surface à structurer (4) représente la surface d'une plaquette de silicium qui est dotée d'une couche d'un agent à structurer.

**7.** Dispositif selon la revendication 5, étant donné que la disposition des avant-bras (2) dans un ensemble (26) est formée comme série, et que la longueur de la série correspond environ au diamètre de la plaquette de silicium qui porte la couche à structurer.

**8.** Dispositif selon la revendication 5, étant donné que la disposition des avant-bras (2) dans l'ensemble (26) est formée comme réseau matriciel planaire.

**9.** Dispositif selon la revendication 8, étant donné que plusieurs réseaux matriciels planaires des avant-bras (2) sont disposés en forme de mosaïque dans l'ensemble (26), et que le réseau en forme de mosaïque correspond approximativement à la surface de la surface à structurer (4) de la plaquette de silicium ou du substrat.

**10.** Dispositif selon l'une quelconque des revendications 1 à 9, étant donné que l'avant-bras (2) est doté de conduites structurées (18a et 19a) pour la commande et le contrôle de l'avant-bras (2), et chaque avant-bras (2) est doté d'une pièce de base (16) sur laquelle plusieurs raccords électriques (19, 20, 21, 22) sont structurés.

**11.** Dispositif selon l'une quelconque des revendications 1 à 10, étant donné que l'actionneur thermique bimorphe (50) se constitue de trois couches, étant donné qu'une première couche (30) est en silicium (Si), une deuxième couche (32) est en dioxyde de silicium ($SiO_2$) et une troisième couche (34) est en aluminium (Al).

**12.** Dispositif selon la revendication 1, étant donné qu'un montage de plusieurs ensembles (26) est formé dans une plaquette de silicium, étant donné que les ensembles (26) individuels sont séparés l'un de l'autre par des nervures (28) en silicium, et la liaison avec l'unité d'alimentation électrique et de contrôle (24) est établie par l'intermédiaire de passages (29) dans les nervures.

**13.** Procédé de microlithographie sans masque avec un dispositif selon l'une quelconque des revendications 1-12 qui comprend les étapes suivantes :

- Combinaison d'au moins un ensemble (26) avec des avant-bras (2), dont chacun porte une pointe d'aiguille (6), avec une surface à structurer (4) de manière à ce que les pointes d'aiguille (6) soient disposées à proximité de la surface à structurer (4),
- détermination d'un décalage de phase des avant-bras (2) dans les ensembles (26) avec une unité d'alimentation électrique et de contrôle (24), et réglage d'une distance entre la pointe d'aiguille (6) prévue à chaque avant-bras (2) et la surface à structurer (4) sur une valeur constante avec l'unité d'alimentation électrique et de contrôle (24), étant donné que le décalage de phase des avant-bras (2) sert de cote pour la distance,
- exécution d'un mouvement relatif entre le au moins un ensemble (26) avec avant-bras (2) et la surface à structurer (4),
- application d'une tension d'anode électrique $V_a$ à la pointe d'aiguille (6) afin, de cette manière, de former un champ électrique entre la pointe d'aiguille et la surface à structurer (4),
- réglage de la tension de cathode $V_k$ et la tension d'anode $V_a$ afin de réguler par l'intermédiaire du rapport de la tension de cathode $V_k$ avec la tension d'anode $V_a$ la taille de point du faisceau d'électrons (E) sur la surface à structurer (4),
- commande de la tension en fonction du dessin à générer sur la surface à structurer (4).

**14.** Procédé selon la revendication 13, étant donné que le distance de la pointe d'aiguille (6) de l'avant-bras (2) à la surface à structurer (2) est modifiée au moyen d'un élément chauffant (15) prévu dans l'avant-bras (2) par alimentation en courant, étant donné qu'un actionneur thermique bimorphe (50) est intégré dans l'avant-bras (2).

**15.** Procédé selon la revendication 13, étant donné que l'unité d'alimentation électrique et de contrôle (24) se compose d'une source de courant (60), un générateur de tension (61), un circuit de blocage de phase (62) et un circuit de contrôle PID (63), étant donné que la source de courant (60) comprend une source de courant alternatif (64), une source de courant PID (65) et une source de courant continu (66).

**16.** Procédé selon la revendication 13, étant donné que le circuit de blocage de phase (62) reçoit la tension mesurée par le capteur piézorésistif (14) et une tension du générateur de tension (61), le circuit de blocage de phase (62) fournit un signal au circuit de contrôle PID (63), le circuit de contrôle PID (63) pour sa part fournit un signal à la source de courant PID (65), et le générateur de tension (61) fournit un signal de courant alternatif à la source de courant alternatif (64).

**17.** Procédé selon la revendication 14, étant donné que le courant de la source de courant alternatif (64), le courant de la source de courant PID (65) et le courant de la source de courant continu (66) sont conduits à l'élément chauffant (15) par l'intermédiaire d'un additionneur (67) dans la source de courant (60).

**18.** Procédé selon la revendication 13, étant donné que le décalage de phase de l'avant-bras (2) est déterminé par l'intermédiaire de l'unité d'alimentation électrique et de contrôle (24) et la distance entre la pointe d'aiguille (6) et la surface à structurer (4) du substrat (5) est adaptée et maintenue constante au moyen de l'unité d'alimentation électrique et de contrôle (24), étant donné que le décalage de phase est maintenu à une valeur constante.

**19.** Procédé selon la revendication 13, étant donné que l'application de la tension électrique à la pointe d'aiguille (6) se fait au moyen de l'unité d'alimentation électrique et de contrôle (24).

**20.** Procédé selon la revendication 19, étant donné que l'unité d'alimentation électrique et de contrôle (24) individuelle est exploitée de manière à ce qu'une tension alternative soit appliquée à l'élément chauffant (15) de manière à ce que les avant-bras (2) soient excités à osciller dans une plage de fréquences de 1-15 MHz.

**21.** Procédé selon la revendication 20, étant donné que la fréquence de résonance et au moins trois modes propres des avant-bras (2) sont situés dans la plage de fréquences dans laquelle les avant-bras (2) oscillent.

2a

2

16

6

8

4

5

**Fig. 1**

6

12

10

**Fig. 2**

EP 1 488 193 B1

$V_A$=100V

*4*

*S*

Spotgröße: 26.4 nm

*E*

$V_K$=50V

*10*

*12*

*6*

*2*

Fig. 3a

$V_A$=100V

*4*

Spotgröße: 27.8 nm

*E*

$V_K$=100V

*10*

*12*

*6*

*2*

Fig. 3b

$V_A$=60V

*4*

Spotgröße: 33.9 nm

*E*

$V_K$=100V

*10*

*12*

*6*

*2*

Fig. 3c

17

**Fig. 4**

**Fig. 6**

Fig. 5

$$I = I_{AC} + I_{DC} + I_{PID}$$

$$U_{AC}(t) = U_0 \sin(\omega t)$$

Fig. 7

Fig. 8

Fig. 9

**Fig. 10**

**Fig. 11**

EP 1 488 193 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0030146 A
- US 6189374 B
- US 5856672 A

**In der Beschreibung aufgeführte Nicht-Patentliteratur**

- **KATHRYN WILDER ; CALVIN F. QUANTE.** *Journal Vac. Sci. Technol. B,* November 1999, vol. 17 (6), 3256-3261
- *J. Vac. Sci. Techn. B,* Juli 1996, vol. 14 (4), 2456
- **S.C. MINNE et al.** *Independent parallel lithography etc*